Europäisches Patentamt

European Patent Office

Office européen des brevets

(11) Veröffentlichungsnummer: **0 054 121**
**A1**

(12) **EUROPÄISCHE PATENTANMELDUNG**

(21) Anmeldenummer: **81108290.8**

(22) Anmeldetag: **13.10.81**

(51) Int. Cl.³: **H 01 L 21/90**
**H 01 L 23/52**

(30) Priorität: **08.12.80 DE 3046189**

(43) Veröffentlichungstag der Anmeldung:
**23.06.82 Patentblatt 82/25**

(84) Benannte Vertragsstaaten:
**AT BE CH FR GB LI NL**

(71) Anmelder: **SIEMENS AKTIENGESELLSCHAFT Berlin und München**
**Postfach 22 02 61**
**D-8000 München 22(DE)**

(72) Erfinder: **Hofmann, Rüdiger, Dr.**
**Ruffinistrasse 16**
**D-8000 München 19(DE)**

(54) Verfahren zur Erzeugung einer Eintransistorspeicherzelle in Einfachsiliziumtechnik.

(57) Die Erfindung bezieht sich auf ein Verfahren zur Erzeugung einer Eintransistorspeicherzelle in Einfachsiliziumgatetechnik mit einer Bitleitung aus dotiertem Material und einer Wortleitung aus Metall. Derartige Speicherzellen haben den Nachteil, daß bei zunehmender Integrationsdichte Laufzeiteffekte auftreten, die die Arbeitsgeschwindigkeit des Bausteins in unerwünschter Weise absenken. Zur Vermeidung dieses Nachteils sieht die Erfindung vor, daß nach der Gateoxydation im späteren Source- und Drainbereich des Auswahltransistors sowie der Speicherkapazität eine Implantation von Elektrizitätsträgern der einen Polarität erfolgt, die im Verlauf eines späteren Prozess-Schrittes im Drain- und Sourcebereich entweder durch eine Implantation oder eine Diffusion mit Elektrizitätsträgern derselben Polarität wie bei der ersten Implantation vervollständigt wird. Beim Aufbringen der Siliziumschicht wird der dotierte Bitleitungsbereich mit einem Polysiliziumstreifen kontaktiert. Die Erfindung läßt sich bei Speichern mit hoher Integrationsdichte, wie z. B. bei 262 k-Bitspeichern anwenden.

FIG 2a

FIG 2b

./...

FIG 2c

FIG 2d

FIG 2d1

FIG 2e

Verfahren zur Erzeugung einer Eintransistorspeicherzelle inEinfachsiliziumtechnik

Die Erfindung betrifft ein Verfahren zur Erzeugung einer Eintransistorspeicherzelle in Einfach-Siliziumtechnik mit einer Bitleitung aus dotiertem Material und einer Wortleitung aus Metall.

In hochintegrierten Speicherbausteinen müssen die einzelnen Bauelemente (wie Transistoren, Widerstände Kapazitäten) mit möglichst kleinem Platzbedarf angeordnet werden. Dieses Problem tritt insbesondere bei Speicherbausteinen hoher und höchster Kapazität (wie z.B. mehr als 65 000 Bit auf einem Chip) bei der Auslegung der Speicherzelle auf.

Die bekannte in dynamisch arbeitenden Speicherbausteinen verwendete Eintransistorzelle besteht aus einem Auswahltransistor, einer Speicherkapazität, einer Bit- und einer Wortleitung sowie im günstigsten Fall aus einem halben Kontakt pro Zelle. Verwendet man zur Herstellung dieser Zelle eine Poly-Silizium-Gate-Technologie wie z.B. die Einfach-Poly-Si-Gate-Technologie, so lassen sich zwei verschiedene Zellmodifikationen unterscheiden: Nämlich die Transistorzelle mit einer Bitleitung aus Metall und der Wortleitung aus Poly-Silizium oder die Eintransistorzelle mit einer Bitleitung aus dotiertem Material (z.B. Diffusion oder Implantation) und der Wortleitung aus Metall.

Beide Ausführungsarten haben als wesentlichen Nachteil,

Zk 1 Stl / 03.12.80

daß auf der jeweils hochohmigen Leitung (Fall 1: Poly-Si-Wortleitung, Fall 2: Diffusionsbitleitung) bei zunehmender Integrationsdichte Laufzeiteffekte auftreten, die die Arbeitsgeschwindigkeit des Bausteins in unerwünschter Weise absenken.

Laufzeiteffekte auf der Poly-Silizium-Wortleitung lassen sich über den Weg einer Silizid-Technologie, wie aus der DBP 28 15 605 bekannt, beheben.

Aufgabe der vorliegenden Erfindung ist es, ein Verfahren anzugeben, mit dem bei Eintransistorspeicherzellen in Einfachsiliziumgatetechnik, bei denen die Wortleitung aus Metall und die Bitleitung aus dotiertem Material besteht, Laufzeiteffekte auf der Bitleitung vermieden werden.

Zur Lösung dieser Aufgabe wird gemäß der Erfindung derart verfahren, daß nach der Gateoxydation im späteren Source- und Drainbereich des Auswahltransistors sowie der Speicherkapazität eine Implantation von Elektrizitätsträgern der einen Polarität erfolgt, die im Verlauf eines späteren Prozess-Schrittes im Drain- und Sourcebereich entweder durch eine Implantation oder eine Diffusion mit Elektrizitätsträgern derselben Polarität vervollständigt wird und daß beim Aufbringen der Siliziumschicht der dotierte Bitleitungsbereich mit einem Polysiliziumstreifen kontaktiert wird.

In weiterer Ausgestaltung der Erfindung kann so verfahren werden, daß nach der Gateoxydation eine Implantation von Elektrizitätsträgern der einen Polarität im späteren Drain-Source- und Speicherkapazitätsgebiet erfolgt, daß anschließend mit einer definierten Dünnoxydätzung das Gebiet der späteren Bitleitung freigelegt wird, daß dann die Polysiliziumschicht abgeschieden und so strukturiert wird, daß auch über der vorgesehenen Bitleitungsfläche ein Polysiliziumstreifen verbleibt, der über den Oxydschlitz Kontakt mit der implantierten Schicht hat, daß dann im Source- und Drainbereich des Auswahltransistors eine zweite Implantation von Elektrizitätsträgern mit derselben Polarität wie bei der ersten Implantation erfolgt und daß der restliche Prozeß wie an sich bekannt verläuft.

Eine andere Verfahrensvariante sieht vor, daß nach der Gateoxydation eine Implantation von Elektrizitätsträgern der einen Polarität im späteren Drain-Source- und Speicherkapazitätsgebiet erfolgt, daß anschließend mit einer definierten Dünnoxydätzung das Gebiet der späteren Bitleitung freigelegt wird, daß dann die Polysiliziumschicht abgeschieden und so strukturiert wird, daß auch über der vorgesehenen Bitleitungsfläche ein Polysiliziumstreifen verbleibt, der über den Oxydschlitz Kontakt mit der implantierten Schicht hat, daß dann im Source- und Drainbereich des Auswahltransistors das Gateoxyd abgeätzt wird und eine Diffusion von Elektrizitätsträgern mit derselben Polarität wie bei der ersten Implantation erfolgt und daß der restliche Prozeß wie an sich bekannt verläuft.

Eine nach dem erfindungsgemäßen Verfahren hergestellte Eintransistorspeicherzelle hat den Vorteil, daß durch Parallelschaltung von dotiertem Bereich und Polysiliziumstreifen die Bitleitung bis zum Faktor 10 niederohmiger ist, als bei bekannten Speicherzellen. Der Auswahltransistor ist dabei selbst justiert und hat eine minimal wählbare und von Justiertoleranzen unabhängige Kanallänge. Durch Wahl des Massepotentials VSS als Deckelektrode erhält man wobbelunempfindliche Speichervaraktoren. Durch Verwendung einer konventionellen Depletionstechnik sind außerdem die Prozeß-Schwierigkeiten sehr gering.

Die Polysiliziumschichten können durch Silizidbildung
zusätzlich niederohmiger gemacht werden.

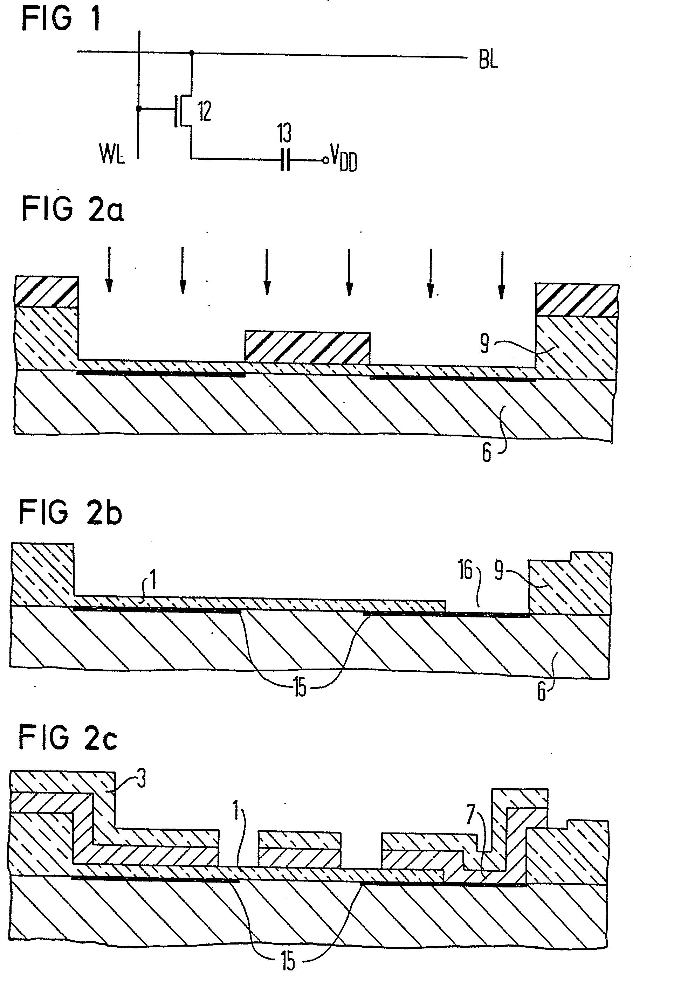

Anhand des Schaltbildes nach Fig. 1 sowie der Querschnittszeichnungen durch einen Speicherbaustein wird die Erfindung näher erläutert.

Es zeigen:
Fig. 1 den Stromlauf einer an sich bekannten Eintransistor-MOS-Speicherzelle,
Fig. 2 Querschnitte durch eine Speicherzelle nach der
        Erfindung bei unterschiedlichen Verfahrensschritten.

In Fig. 1 ist eine bekannte Eintransistorspeicherzelle
dargestellt. Der Auswahltransistor 12 ist mit seiner
Drain-Elektrode mit der Bitleitung BL und mit seiner
Gateelektrode mit der Wortleitung WL verbunden. Die
Source-Elektrode ist über den Speicherkondensator 13
an das Potential VDD geführt.

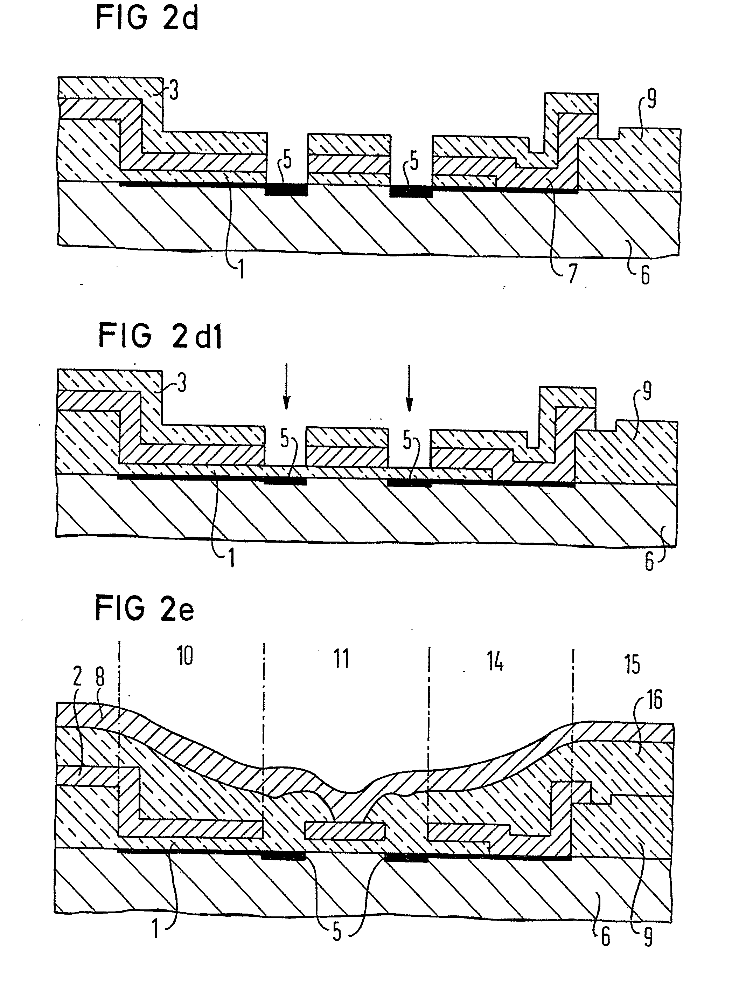

In Fig. 2 ist der Querschnitt einer in Einfachsiliziumtechnik hergestellten Speicherzelle nach der Erfindung
gezeigt.

Nach dem Aufbringen des Gateoxyds 1 auf das Substrat 6,
das im vorliegenden Fall ein P-Substrat sein soll, wird
der Bereich des späteren Auswahltransistors mit einer
Depletion-Maske abgedeckt, die ein entsprechender Fotolack sein kann. Anschließend wird eine $n^+$-Implantation
durch das Gateoxyd 1 hindurch vorgenommen (Fig. 2a).
Danach muß im Bereich 16 der späteren Bitleitung das
Gateoxyd 1 durch eine sogenannte A/B-Kontaktlochätzung
beseitigt werden (Fig. 2b). Im Anschluß daran erfolgt
die Abscheidung und in bekannter Weise die Strukturierung der Polysiliziumschicht 2 über ein darüberliegendes Maskieroxyd 3. Diese Polysiliziumschicht kommt dabei auch unmittelbar mit dem für die Bitleitung vorgesehenen Dotierungsbereich in Berührung. Sie bleibt dort als Siliziumstreifen 7 stehen (FIG 2c). Nach dem Strukturieren des Polysiliziums 2 wird das Gateoxyd 1 im Source- und Drainbereich des Transistors weggeätzt, wobei als Ätzmaske für die Oxydätzung die Polysilizumschicht 2, 7 dient. Danach erfolgt eine $n^+$-Diffusion der Source- und Drainbereiche 5 (FIG 2d).

Eine andere Variante des Verfahrens sieht sofort nach dem Aufbringen des Maskieroxyds eine $n^+$-Implantation im Source- und Drainbereich des Auswahltransistors vor. Hierbei dient die Polysiliziumschicht als Implantationsmaske. Die Implantation läßt sich dadurch selbstjustierend vornehmen (FIG 2d1).

Die weiteren Prozeß-Schritte verlaufen dann in der bekannten Art und Weise. In FIG 2e ist eine endgültig strukturierte MOS-Speicherzelle nach der Erfindung gezeigt. Die hierfür erforderlichen Prozeß-Schritte zur Aufbringung des Zwischenoxyds 16 und der Aluminiumschicht 8 für den Wortleitungskontakt werden dabei wie bekannt vorgenommen, so daß dies nicht näher erläutert werden braucht. Die Bereiche in der so strukturierten Speicherzelle ergeben sich von links nach rechts wie folgt: Ganz links befindet sich der Depletionvaraktor 10, daran anschließend der selbstjusiterte Transistor mit dem Wortleitungskontakt 11, dann der niederohmige Bitleitungsbereich 14 und anschließend der Feldbereich 15.

2 Figuren

4 Patentansprüche.

Patentansprüche

1. Verfahren zur Erzeugung einer Eintransistorspeicherzelle in Einfach-Siliziumgatetechnik mit einer Bitleitung aus dotiertem Material und einer Wortleitung aus Metall, d a d u r c h   g e k e n n z e i c h n e t , daß nach der Gateoxydation im späteren Source- und Drainbereich des Auswahltransistors sowie der Speicherkapazität eine Implantation von Elektrizitätsträgern der einen Polarität erfolgt, die im Verlauf eines späteren Prozeß-Schrittes im Drain- und Sourcebereich entweder durch eine Implantation oder eine Diffusion mit Elektrizitätsträgern derselben Polarität wie bei der ersten Implantation ver-vollständigt wird und daß beim Aufbringen der Siliziumschicht der dotierte Bitleitungsbereich mit einem Polysiliziumstreifen kontaktiert wird.

2. Verfahren nach Anspruch 1, d a d u r c h   g e - k e n n z e i c h n e t , daß nach der Gateoxydation eine Implantation von Elektrizitätsträgern der einen Polarität im späteren Drain-Source- und Speicherkapazitätsgebiet erfolgt, daß anschließend mit einer definierten Dünnoxydätzung das Gebiet (16) der späteren Bitleitung freigelegt wird, daß dann die Polysiliziumschicht (2) abgeschieden und so strukturiert wird, daß auch über der vorgesehenen Bitleitungsfläche (16) ein Polysiliziumstreifen (7) verbleibt, der über den Oxydschlitz Kontakt mit der implantierten Schicht hat, daß dann im Source- und Drainbereich des Auswahltransistors eine zweite Implantation von Elektrzitätsträgern mit derselben Polarität wie bei der ersten Implantation erfolgt und daß der restliche Prozeß wie an sich bekannt verläuft.

3. Verfahren nach Anspruch 1, d a d u r c h   g e - k e n n z e i c h n e t , daß nach der Gateoxydation eine Implantation von Elektrizitätsträgern der einen Polarität im späteren Drain-Source- und Speicherkapazitätsgebiet erfolgt, daß anschließend mit einer definierten Dünnoxydätzung das Gebiet (16) der späteren Bitleitung freigelegt wird, daß dann die Polysiliziumschicht (2) abgeschieden und so strukturiert wird, daß auch über der vorgesehenen Bitleitungsfläche ein Polysiliziumstreifen (7) verbleibt, der über den Oxydschlitz Kontakt mit der implantierten Schicht hat, daß dann im Source- und Drainbereich des Auswahltransistors das Gateoxyd (1) abgeätzt wird und eine Diffusion von Elektrizitätsträgern mit derselben Polarität wie bei der ersten Implantation erfolgt und daß der restliche Prozeß wie an sich bekannt verläuft.

4. Verfahren nach einem der vorhergehenden Ansprüche, d a d u r c h   g e k e n n z e i c h n e t , daß auf der Polysiliziumschicht Silizid abgeschieden wird.

FIG 1

FIG 2a

FIG 2b

FIG 2c

FIG 2d

FIG 2 d1

FIG 2e

Europäisches
Patentamt

**EUROPÄISCHER RECHERCHENBERICHT**

Nummer der Anmeldung

EP 81 10 8290

| | EINSCHLÄGIGE DOKUMENTE | | KLASSIFIKATION DER ANMELDUNG (Int Cl.·) |
|---|---|---|---|
| Kategorie | Kennzeichnung des Dokuments mit Angabe, soweit erforderlich, der maßgeblichen Teile | betrifft Anspruch | |
| Y | IBM TECHNICAL DISCLOSURE BULLETIN, Band 23, No. 6, November 1980, NEW YORK (US) V.L. RIDEOUT: "Method of Fabricating MOSFET Integrated Circuits with Low Resistivity Interconnection Lines" Seiten 2563-2566 <br><br> * Figuren 1C,1D; Seite 2564, Absatz 3; Seite 2565, Absatz 1: Seite 2566, Absatz 2 * <br><br> -- | 1,2,4 | H 01 L 21/90 H 01 L 23/52 |
| Y | IBM TECHNICAL DISCLOSURE BULLETIN, Band 23, No. 6, November 1980 NEW YORK (US) F.H. DE LA MONEDA: "Process to Minimize the Area of One-Device Memory Cells and Reduce Bit Line Capacitance" Seiten 2368-2371 <br><br> * Seite 2368, Absatz 1; Seite 2370, Absatz 2; Seite 2371, Absatz 5 * <br><br> ---- | 1-4 | RECHERCHIERTE SACHGEBIETE (Int. Cl.³) <br><br> H 01 L |

KATEGORIE DER GENANNTEN DOKUMENTE

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument, das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 26-03-1982 | DE RAEVE |

EPA form 1503.1   06.78